(19) **Europäisches Patentamt / European Patent Office / Office européen des brevets**

(11) **EP 3 210 006 B1**

(12) **FASCICULE DE BREVET EUROPEEN**

(45) Date de publication et mention
de la délivrance du brevet:
**08.05.2019 Bulletin 2019/19**

(21) Numéro de dépôt: **15791698.2**

(22) Date de dépôt: **20.10.2015**

(51) Int Cl.:
*G01N 27/04* (2006.01)  *G01N 21/3563* (2014.01)
*G01N 21/95* (2006.01)

(86) Numéro de dépôt international:
**PCT/FR2015/052821**

(87) Numéro de publication internationale:
**WO 2016/062966 (28.04.2016 Gazette 2016/17)**

(54) **PROCÉDÉ DE CARACTÉRISATION DE LA CONCENTRATION EN OXYGÈNE INTERSTITIEL DANS UN LINGOT SEMI-CONDUCTEUR**

VERFAHREN ZUR CHARAKTERISIERUNG DER INTERSTITIELLEN SAUERSTOFFKONZENTRATION IN EINEM HALBLEITERINGOT

METHOD FOR CHARACTERIZING THE INTERSTITIAL OXYGEN CONCENTRATION IN A SEMICONDUCTOR INGOT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.10.2014 FR 1460152**

(43) Date de publication de la demande:
**30.08.2017 Bulletin 2017/35**

(73) Titulaire: **Commissariat à l'Énergie Atomique et aux Énergies Alternatives 75015 Paris (FR)**

(72) Inventeurs:
• **CASCANT-LOPEZ, Miguel**
 **F-73000 Chambery (FR)**
• **TOMASSINI, Mathieu**
 **F-38570 Hurtières (FR)**

• **VEIRMAN, Jordi**
 **F-74330 Poisy (FR)**

(74) Mandataire: **Cabinet Camus Lebkiri 25 rue de Maubeuge 75009 Paris (FR)**

(56) Documents cités:
**EP-A1- 0 668 613    US-A- 4 436 577 US-A- 5 550 374**

• **FUSEGAWA I ET AL: "Characterization of interstitial oxygen striations in silicon single crystals", JOURNAL OF CRYSTAL GROWTH, ELSEVIER, AMSTERDAM, NL, vol. 128, no. 1-4, 1 mars 1993 (1993-03-01), pages 293-297, XP024438628, ISSN: 0022-0248, DOI: 10.1016/0022-0248(93)90336-U [extrait le 1993-03-01]**

EP 3 210 006 B1

**Description**

**DOMAINE TECHNIQUE**

La présente invention est relative à un procédé de caractérisation de la teneur en oxygène dans un lingot en matériau semi-conducteur, par exemple un lingot en silicium monocristallin obtenu par le procédé Czochralski.

**ETAT DE LA TECHNIQUE**

Les lingots en silicium destinés à l'industrie microélectronique ou aux applications photovoltaïques comprennent de l'oxygène. Les atomes d'oxygène occupent des positions interstitielles dans le réseau cristallin. Dans le cas du silicium monocristallin CZ (i.e. obtenu par le procédé Czochralski) ou dans le cas du silicium polycristallin, la concentration en oxygène interstitiel ($[O_i]$) varie entre $10^{16}$ et $2.10^{18}$ cm$^{-3}$.

Pour les fabricants de lingots, il est important de connaître la répartition de l'oxygène en position interstitielle au sein du lingot, car cette impureté peut donner naissance à de nombreux défauts pendant le refroidissement du lingot ou pendant les procédés ultérieurs de fabrication des dispositifs semi-conducteurs. En particulier, à des températures comprises entre 350 °C et 500 °C, l'oxygène forme des agglomérats appelés donneurs thermiques qui affectent les propriétés électriques du matériau en créant des électrons libres. A plus haute température, l'oxygène forme des précipités permettant de piéger des impuretés métalliques présentes dans le silicium. Un effet getter peut ainsi être obtenu. Enfin, pour les applications photovoltaïques, une concentration en oxygène élevée entraîne une diminution des performances, notamment une diminution du rendement de conversion sous éclairement des cellules photovoltaïques à base de bore, du fait de l'activation de complexes bore-oxygène.

Plusieurs techniques de mesure de la concentration en oxygène interstitiel ont été développées, afin de déterminer localement l'influence de l'oxygène sur les propriétés électriques et mécaniques du silicium.

Le brevet FR2964459 décrit un procédé de cartographie de la concentration en oxygène interstitiel, dans lequel une plaquette de silicium est soumise à un traitement thermique pour former des donneurs thermiques. Connaissant la résistivité électrique du matériau après le traitement thermique et les concentrations initiales en dopants, la concentration en donneurs thermiques dans chaque zone de la plaquette peut être calculée. Puis, la concentration en oxygène interstitiel dans chaque zone est déterminée à partir de la concentration en donneurs thermiques.

Cette première technique peut être utilisée afin de reconstruire la cartographie en oxygène du lingot entier. Cela nécessite cependant le découpage du lingot en une multitude de plaquettes et la reproduction des étapes du procédé sur toutes les plaquettes issues du lingot (ou a minima sur une large sélection d'entre elles). Cette technique pour déterminer la teneur en oxygène interstitiel au sein du lingot est par conséquent longue et coûteuse.

Le brevet EP0020993 décrit une autre technique de mesure indirecte de la teneur en oxygène interstitiel dans un lingot de silicium CZ, basée également sur la formation de donneurs thermiques. Une tranche d'environ 1 cm d'épaisseur est découpée en tête de lingot, puis soumise à un recuit entre 600 °C et 900 °C pendant une durée comprise entre 1 heure et 10 heures. Ce recuit provoque un incrément de résistivité, qui est ensuite mesuré et auquel correspond une certaine concentration de donneurs thermiques. Au moyen d'abaques, on détermine la teneur en oxygène à partir de l'incrément de résistivité.

Comme la première technique, cette deuxième technique est fastidieuse car elle requiert de découper entièrement le lingot sous forme de tranches et de mesurer la concentration en oxygène tranche après tranche, afin de caractériser le lingot dans son ensemble. En outre, le recuit préconisé dans le brevet EP0020993 (dans la gamme 600°C~900 °C) peut conduire à une précipitation importante de l'oxygène, se traduisant par une diminution des propriétés électroniques du matériau (par exemple une baisse de la durée de vie des porteurs). Enfin, cette deuxième technique requiert au préalable une étape dite de stabilisation (i.e. une étape de recuit entre 550 °C et 650 °C pendant 1 heure à 5 heures) qui, en plus d'être coûteuse en énergie, peut également nuire à la qualité électrique du matériau.

La seule technique connue permettant de caractériser directement le lingot, c'est-à-dire avant sa découpe en une pluralité de plaquettes ou tranches, est une technique de spectroscopie infrarouge communément appelée « Whole-rod FTIR ». Cette technique, dérivée de la spectroscopie infrarouge à transformée de Fourier (FTIR) habituellement appliquée à l'échelle d'une plaquette, consiste à scanner le lingot avec un faisceau infrarouge, ce faisceau se déplaçant parallèlement à l'axe de tirage du lingot. L'absorption du faisceau infrarouge par le lingot permet de déterminer une concentration moyenne de l'oxygène dans le lingot.

La mesure par « Whole-rod FTIR » présente de nombreux inconvénients : elle est particulièrement coûteuse et nécessite une rectification de la surface du lingot, afin de contrôler la pénétration du faisceau. En outre, elle ne donne aucune indication sur la distribution radiale de l'oxygène dans le lingot, car la valeur mesurée est une moyenne de la concentration en oxygène sur toute l'épaisseur du lingot.

**RESUME DE L'INVENTION**

Il existe donc un besoin de prévoir un procédé de caractérisation de la concentration en oxygène interstitiel dans un lingot en matériau semi-conducteur, qui soit précis, rapide et peu coûteux à mettre en oeuvre et qui évite de découper entièrement le lingot en plaquettes.

Selon l'invention, on tend à satisfaire ce besoin en prévoyant un procédé de caractérisation comprenant les étapes suivantes :

a) découper dans le lingot un tronçon selon un plan longitudinal du lingot ;

b) mesurer la concentration en oxygène interstitiel en plusieurs points répartis sur une largeur du tronçon dans le plan de coupe longitudinal du lingot ;

c) convertir les mesures de la concentration en oxygène interstitiel sur la largeur du tronçon en des mesures de la concentration en oxygène interstitiel sur une profondeur du tronçon ;

d) extrapoler un profil radial de la concentration en oxygène interstitiel dans le lingot à partir des mesures de la concentration en oxygène interstitiel sur la profondeur du tronçon ;

e) répéter les étapes b) à d) en différentes zones réparties le long du tronçon, d'où il résulte une pluralité de profils radiaux de la concentration en oxygène interstitiel dans le lingot ; et

f) corréler les profils radiaux pour déterminer la concentration en oxygène interstitiel dans chaque zone du lingot.

Ce procédé de caractérisation peut également présenter une ou plusieurs des caractéristiques ci-dessous, considérées individuellement ou selon toutes les combinaisons techniquement possibles :

- le procédé comprend une étape de détermination d'un gradient de la concentration en oxygène sur un rayon du lingot, à partir des mesures de la concentration en oxygène interstitiel sur la profondeur du tronçon, le profil radial de la concentration en oxygène interstitiel étant extrapolé à l'étape d) au moyen dudit gradient de la concentration en oxygène ;
- le découpage du tronçon dans le lingot est réalisé de sorte que le tronçon ait une épaisseur maximale supérieure ou égale à 2 cm ;
- les mesures de la concentration en oxygène interstitiel sur la largeur du tronçon sont converties en mesures de la concentration en oxygène interstitiel sur une profondeur du tronçon en déterminant, pour chaque point de mesure, la profondeur équivalente dans le tronçon ;
- les étapes b) à d) sont répétées en au moins cinq zones du lingot ;
- la concentration en oxygène interstitiel peut être mesurée selon les étapes du procédé selon la revendication 6.

**BREVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1 représente un lingot en silicium dans lequel ont été découpés un tronçon et une plaquette de silicium ;
- la figure 2A représente des mesures de la concentration en oxygène interstitiel réparties sur un rayon de la plaquette de la figure 1 ;
- la figure 2B représente des mesures de la concentration en oxygène interstitiel réparties sur la longueur du tronçon de la figure 1 ;
- la figure 3A est un exemple de relevé des mesures de la figure 2A ;
- la figure 3B est un exemple de relevé des mesures de la figure 2B ;
- la figure 3C est une cartographie de la concentration en oxygène interstitiel dans le lingot, obtenue à partir des relevés des figures 3A et 3B ;
- la figure 4 est une vue de dessus du lingot de la figure 1 montrant l'équivalence entre les mesures de la concentration en oxygène interstitiel sur la largeur du tronçon (dans le plan de coupe du tronçon) et les mesures de la concentration en oxygène interstitiel sur la profondeur du tronçon (perpendiculairement au plan de coupe) ;
- la figure 5 est un exemple d'abaque permettant la conversion entre largeur et profondeur du tronçon ;
- la figure 6 représente un profil radial de la concentration en oxygène interstitiel extrapolé à partir des mesures sur la profondeur du tronçon, selon un premier mode de mise en oeuvre du procédé de caractérisation selon l'invention ;
- la figure 7A représente une étape de calcul du gradient de la concentration en oxygène à partir des mesures sur la profondeur du tronçon ;
- la figure 7B représente l'extrapolation du profil radial de la concentration en oxygène interstitiel à partir des mesures sur la profondeur du tronçon et du gradient calculé à l'étape de la figure 7A, d'après un deuxième mode de mise en oeuvre du procédé de caractérisation selon l'invention ;

- la figure 8 montre deux profils radiaux de la concentration en oxygène, l'un étant mesuré sur une plaquette, l'autre étant obtenu par extrapolation des mesures sur le tronçon ;
- la figure 9 est un organigramme permettant de déterminer si la variation relative radiale en oxygène est conservée tout au long du lingot ; et
- la figure 10 représente en vue de face le tronçon sur lesquels sont mesurés deux profils longitudinaux de la concentration en oxygène interstitiel, d'après la première étape de l'organigramme de la figure 9.

Pour plus de clarté, les éléments identiques ou similaires sont repérés par des signes de références identiques sur l'ensemble des figures.

## DESCRIPTION DETAILLEE D'AU MOINS UN MODE DE REALISATION

Dans la description qui suit, on présente deux techniques permettant de caractériser la concentration (ou teneur) en oxygène interstitiel au sein d'un lingot en matériau semi-conducteur. Ces deux techniques ont en commun la découpe d'un tronçon longitudinal - appelé « slab » en anglais - dans le lingot et la réalisation de mesures de la concentration en oxygène interstitiel sur ce tronçon.

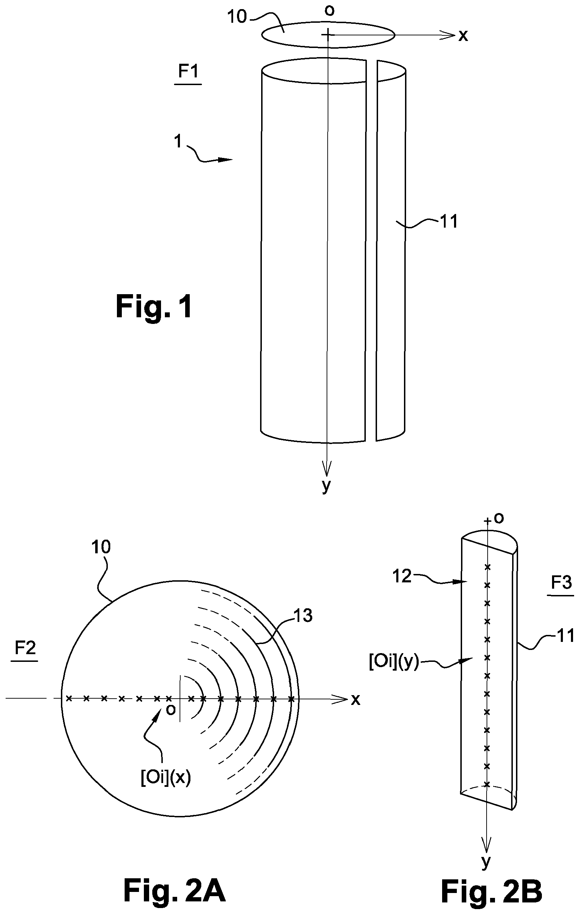

Les figures 1, 2A et 2B représentent respectivement des étapes F1, F2 et F3 d'un premier procédé de caractérisation de la concentration en oxygène interstitiel faisant intervenir ce tronçon longitudinal. Ce premier procédé de caractérisation ne fait pas partie de l'invention revendiquée.

La figure 1 montre un lingot 1 en matériau semi-conducteur, par exemple un lingot en silicium monocristallin tiré selon la méthode Czochralski qui sert à fabriquer des plaquettes de silicium pour l'industrie microélectronique ou photovoltaïque. Le lingot 1 se présente sous la forme d'un cylindre de révolution, dont l'axe Oy correspond à l'axe de tirage du lingot.

A l'étape F1, une plaquette de silicium 10, aussi appelée tranche, est découpée dans le lingot 1 selon un plan de coupe transversal, c'est-à-dire perpendiculaire à l'axe Oy du lingot. Comme cela est illustré sur la figure 1, la plaquette 10 est de préférence découpée à l'une des extrémités du lingot : la tête (partie du lingot solidifiée en premier lors du tirage, i.e. du côté du germe) ou le pied (partie du lingot solidifiée en dernier) du lingot. La découpe en est simplifiée et cela permet d'utiliser avantageusement la chute haute ou basse du lingot.

Un tronçon 11 est en outre découpé dans le lingot 1 selon un plan de coupe longitudinal, c'est-à-dire parallèlement à l'axe Oy du lingot, et de préférence sur toute la longueur du lingot 1. Cette découpe verticale est habituellement pratiquée pour la réalisation d'un méplat, que l'on retrouve ensuite sur chaque plaquette de silicium lors de la fabrication des circuits intégrés, ou pour réaliser l'étape dite de « squaring » (ou « pseudo-squaring ») qui donne aux cellules photovoltaïques leur forme carrée (ou sensiblement carrée). Ainsi, la découpe du tronçon 11 n'est pas seulement réalisée pour les besoins du procédé de caractérisation. Elle constitue également une étape courante dans la préparation des substrats semi-conducteurs et notamment pour le photovoltaïque. Par conséquent, son coût financier dans le procédé de caractérisation peut être considéré comme nul.

A l'étape F2 représentée par la figure 2A, on réalise une première série de mesures de la concentration en oxygène interstitiel [Oi] en différentes zones de la plaquette 10. Les zones mesurées sont réparties sur un axe Ox correspondant à un rayon de la plaquette 10. On parle alors de mesures radiales [Oi](x) de la concentration en oxygène interstitiel.

L'étape F3 de la figure 2B consiste à réaliser une deuxième série de mesures de la concentration en oxygène interstitiel dans le tronçon 11. Ces mesures sont alignées et réparties dans le sens de la longueur du tronçon 11, c'est-à-dire selon un axe parallèle à l'axe Oy. Pour cette raison, elles peuvent être qualifiées de mesures longitudinales [Oi](y).

Les mesures longitudinales [Oi](y) sont, de préférence, effectuées sur une face plane 12 du tronçon 11 obtenue en découpant le lingot selon le plan de coupe longitudinal, plutôt que sur la face arrondie du tronçon 11 qui correspond au bord du lingot 1. En effet, cette surface plane 12 facilite grandement les mesures de la concentration en oxygène, quelle que soit la technique de mesure utilisée.

Lors des étapes F2 et F3, les mesures de la concentration en oxygène interstitiel peuvent être réalisées par spectroscopie infrarouge à transformée de Fourier (FTIR) ou par analyse chimiques de type SIMS (« Secondary Ion Mass Spectrometry ») ou IGA (« Instrumental Gas Analysis »). Dans le cas du FTIR, le tronçon 11 subit en outre un polissage mécano-chimique de sa face arrondie, afin de rendre celle-ci plane et parallèle à la face 12.

Dans un mode de mise en oeuvre préférentiel des étapes F2 et F3, les mesures [Oi](x) et [Oi](y) sont effectuées conformément à l'enseignement du brevet FR2964459 susmentionné, au moyen d'un recuit de formation des donneurs thermiques à moyenne température (350 °C-500 °C) et d'une mesure de la résistivité électrique après recuit. La concentration en donneurs thermiques est calculée à partir de la variation de la résistivité, connaissant la résistivité après recuit et la résistivité initiale (avant recuit) ou les concentrations initiales en dopants. Puis, la concentration en oxygène interstitiel [Oi] est déterminée à partir de la concentration en donneurs thermiques. Avantageusement, un second recuit est réalisé à une température supérieure à 600 °C après la mesure de résistivité, afin de détruire les donneurs thermiques et restituer l'échantillon dans son état initial. Ce second recuit permet également de déterminer, si besoin, les concentrations initiales en dopants. Les mesures de résistivité peuvent être obtenues par la méthode des 4 pointes ou par toute technique alternative, comme la méthode par courant de Foucault. La valeur du courant injecté dans le cadre de la méthode des 4 pointes ou la fréquence du champ magnétique généré dans le cadre de la méthode par courant de Foucault pourront être des valeurs classiques rencontrées dans la littérature ou ajustées de façon à mesurer la résistivité en surface de l'échantillon (typiquement sur une profondeur d'un millimètre).

L'ordre dans lequel sont effectuées les mesures radiales [Oi](x) et longitudinales [Oi](y) de la concentration en oxygène est sans importance. Autrement dit, l'étape F3 peut succéder à l'étape F2, ou inversement.

En général, la variation de la concentration en oxygène qu'on observe radialement sur une plaquette se reproduit dans des proportions sensiblement identiques tout au long du lingot (avec une tolérance de +/- 10%). C'est notamment le cas lorsque le lingot a été tiré selon la méthode Czochralski ou pour une brique de silicium polycristallin découpée dans un lingot. A titre d'exemple, si la concentration en oxygène augmente de 20% du bord extérieur vers le centre de la plaquette, on peut supposer qu'il en est de même sur toute la longueur du lingot, et donc pour toutes les autres plaquettes qui pourront être issues du lingot.

Les mesures [Oi](x) de la figure 2A visent justement à déterminer cette variation relative radiale, c'est-à-dire dans quelle mesure varie la concentration en oxygène sur un rayon de la plaquette 10. On notera à cet égard qu'il n'est pas indispensable de mesurer la concentration [Oi] sur plusieurs rayons de la plaquette 10, car il peut être admis que la plaquette présente des isocourbes circulaires de la teneur en oxygène. C'est notamment le cas pour un lingot Cz du fait de la symétrie de révolution du four de tirage. En d'autres termes, la concentration [Oi] est supposée constante sur tout le périmètre d'un cercle 13 dont le centre est confondu avec le centre O de la plaquette (Fig.2). Par conséquent, les valeurs de la concentration [Oi] sur un seul rayon Ox suffisent à établir la cartographie complète d'une plaquette.

Par ailleurs, grâce aux mesures longitudinales [Oi](y) du tronçon (Fig.2B), on connait une valeur de la concentration en oxygène pour différentes positions sur l'axe Oy et une même position sur l'axe Ox (le tronçon étant découpé perpendiculairement à l'axe Ox). Ces valeurs [Oi](y) constituent des références auxquelles vont être appliquée la variation radiale de la concentration en oxygène mesurée à l'étape F2.

Ainsi, lors d'une dernière étape du procédé non représentée sur les figures, les mesures radiales [Oi](x) sont combinées aux mesures longitudinales [Oi](y), afin d'établir une cartographie complète de la concentration en oxygène interstitiel dans le lingot.

Pour ce faire, les mesures longitudinales [Oi](y) peuvent être décrites par une fonction mathématique f(y), de préférence une fonction polynomiale. On ajuste les coefficients du polynôme jusqu'à ce que la courbe représentative de la fonction f coïncide avec les valeurs des mesures longitudinales [Oi](y). On peut ensuite calculer aisément la concentration en oxygène en tout point du lingot. La concentration en oxygène d'un point de coordonnées (x, y), où x est la coordonnée radiale et y une fraction de la longueur totale du lingot (i.e. la « hauteur » du point dans le lingot 1 de la figure 1), s'écrit :

$$[Oi](x,y) = [Oi](x) * f(y)$$

A l'inverse, les mesures radiales [Oi](x) peuvent être décrites par une fonction polynomiale f(x) (qui représente donc la variation relative radiale) puis cette fonction est multipliée par les mesures longitudinales [Oi](y) de la concentration en oxygène comme suit :

$$[Oi](x,y) = [Oi](y) * f(x)$$

On peut aussi convertir en polynôme à la fois les mesures radiales [Oi](x) et les mesures longitudinales [Oi](y) pour en déduire facilement la concentration [Oi] en tout point de cordonnées x et y.

Bien sûr, plus le nombre de mesures radiales et le nombre de mesures longitudinales sont importants, plus la cartographie du lingot entier peut être fine et précise. Ces nombres peuvent notamment dépendre des dimensions (diamètre et longueur) du lingot. A titre d'exemple, pour un lingot de 200 mm de diamètre (8 pouces) et 2 m de longueur, le nombre de mesures radiales est avantageusement supérieur à 5 tandis que le nombre de mesures longitudinales est avantageusement supérieur à 10, préférentiellement supérieur à 20.

Par ailleurs, il peut être avantageux d'étendre la première série de mesures de la concentration en oxygène interstitiel sur un diamètre de la plaquette 10 (soit l'équivalent de deux rayons), comme cela est schématiquement représenté sur la figure 2A. Cela permet d'augmenter la précision du procédé de caractérisation (on s'affranchit alors de l'hypothèse selon laquelle la concentration en oxygène est symétrique). En outre, afin de vérifier la robustesse du procédé de caractérisation, on peut découper plus d'une plaquette et réaliser d'autres mesures radiales de la concentration en oxygène pour les corréler entre elles.

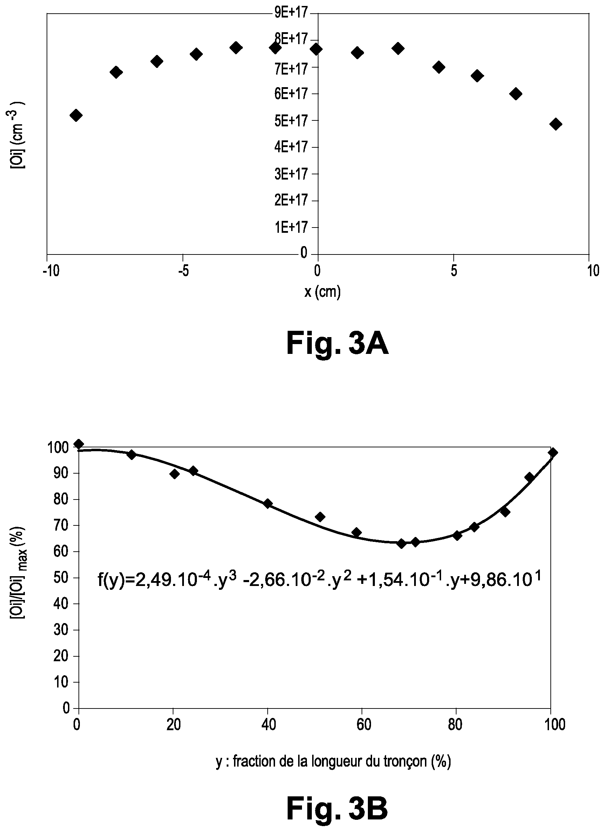

Les figures 3A à 3C représentent un exemple de mise en oeuvre de ce premier procédé de caractérisation de la concentration en oxygène interstitiel. Le relevé de la figure 3A correspond aux mesures [Oi](x) obtenues sur le diamètre d'une plaquette 10 de 200 mm de diamètre, conformément à l'étape F2 de la figure 2A. La figure 3B montre des mesures longitudinales [Oi](y) de la concentration en oxygène en surface du tronçon 11 de la figure 2B. On notera que la concentration en oxygène représentée en ordonnées de la figure 3B est une concentration relative, c'est-à-dire rapportée à la valeur maximale mesurée sur le tronçon et donc exprimée en pourcentage, tandis que l'abscisse « y » correspond à la fraction du lingot, également exprimée en pourcentage.

Ces deux séries de mesures de la concentration en oxygène ont été obtenues grâce à la technique décrite dans le brevet FR2964459, avec un recuit à 450°C pendant 3 heures et des mesures de résistivité effectuées selon la méthode des quatre pointes.

Une fonction polynomiale f(y) représentative des mesures longitudinales peut ensuite être déterminée numériquement. Dans le cas de la figure 3B, cette fonction vaut :

$$f(y) = 2,49.10^{-4}.y^3 - 2,66.10^{-2}.y^2 + 1,54.10^{-01}.y + 9,86.10^1$$

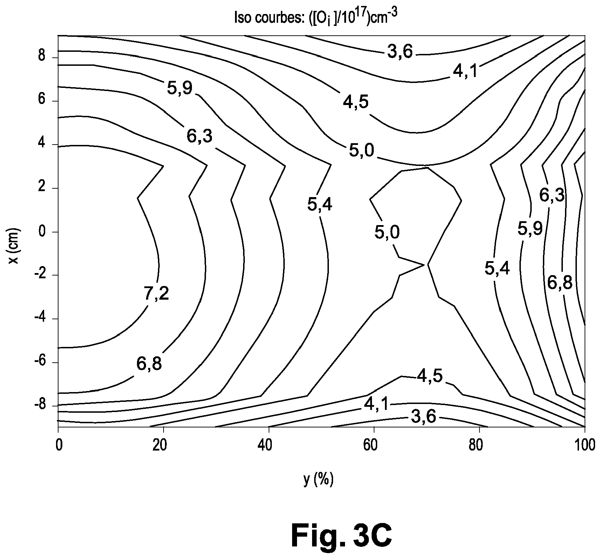

En multipliant les valeurs de concentration [Oi](x) de la figure 3A par la fonction f(y) de la figure 3B, on obtient la cartographie de la figure 3C qui représente la concentration en oxygène interstitiel dans tout le lingot. Chaque zone dans le lingot est repérée par deux coordonnées : la position radiale x (telle qu'illustrée sur la figure 2A) et la fraction du lingot y (exprimée en pourcentage de la longueur totale du lingot).

Ce procédé de caractérisation permet donc, à l'aide de mesures de la concentration en oxygène judicieusement choisies, d'établir une cartographie complète du lingot. Contrairement aux procédés de l'art antérieur, il n'est pas nécessaire de découper entièrement le lingot en plaquettes. Il suffit d'une plaquette découpée transversalement et d'un tronçon longitudinal ou « slab ». Le nombre de mesures nécessaires est limité à ces deux portions de lingot, ce qui rend le procédé particulièrement rapide à mettre en oeuvre.

La connaissance de la répartition tridimensionnelle en oxygène à l'échelle du lingot est une information essentielle, car elle permet d'identifier rapidement quelles sont les portions du lingot qui satisfont aux spécifications en oxygène. Cela permet de sélectionner puis de découper en plaquettes uniquement ces portions de lingot, ce qui représente un gain de temps considérable pour le fabricant des plaquettes. Dans les procédés de caractérisation de l'art antérieur, une telle connaissance ne peut pas obtenue qu'à l'issue du découpage en plaquettes.

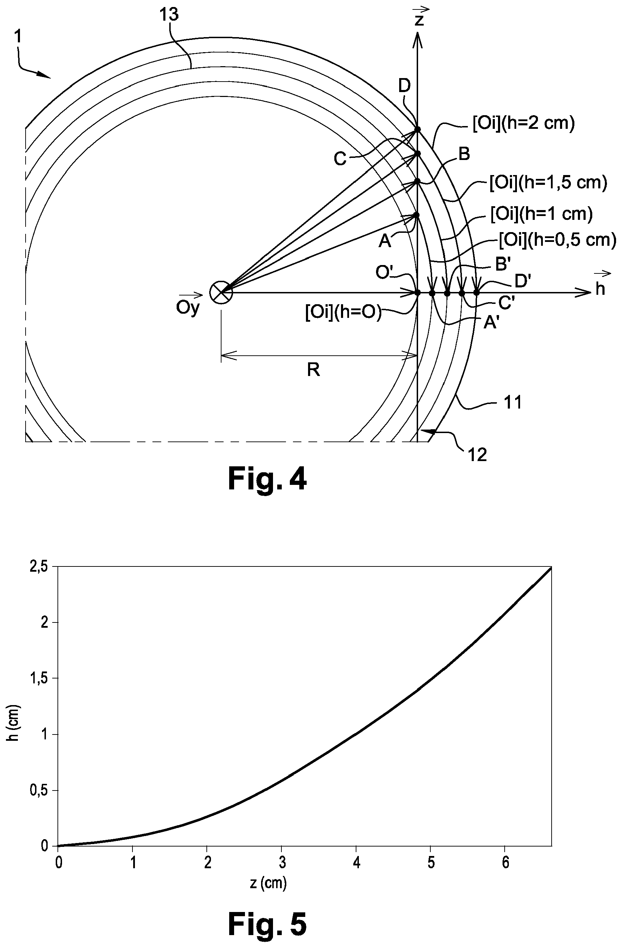

Jusqu'à présent, il a été fait l'hypothèse que la variation radiale relative (en pourcentage) de la concentration en oxygène observée sur une plaquette est conservée tout au long du lingot. On va donc maintenant décrire en relation avec les figures 4 à 8 un deuxième procédé de caractérisation qui se dispense de cette hypothèse.

Ce deuxième procédé utilise de façon avantageuse le tronçon 11 du lingot pour déterminer la distribution radiale en oxygène interstitiel, pour différentes positions choisies le long du lingot.

La figure 4 est une vue de dessus du lingot 1 et de son tronçon longitudinal 11. On appelle ci-après « profondeur » la dimension h du tronçon 11 selon un axe $\vec{h}$ qui s'étend perpendiculairement à la face plane 12 du tronçon et dont l'origine O' est située sur cette face 12. La largeur z du tronçon 11 désigne la dimension selon un axe $\vec{z}$ perpendiculaire à l'axe $\vec{h}$ (pour mémoire, la longueur du tronçon 11 est la dimension mesurée parallèlement à l'axe Oy du lingot). L'origine O' de ce nouveau repère est, de préférence, positionnée à la moitié de la largeur totale du tronçon 11, où la profondeur h du tronçon est maximale.

Comme expliqué précédemment, le lingot 1 présente des isocourbes de la concentration en oxygène interstitiel [Oi] en forme de cercles concentriques 13, c'est-à-dire des courbes sur lesquelles la concentration [Oi] est constante. Il en découle qu'une valeur de la concentration [Oi] mesurée sur la face plane 12 du tronçon 11 le long de l'axe $\vec{z}$ équivaut à une mesure de la concentration [Oi] à une certaine profondeur h du tronçon (i.e. sur l'axe $\vec{h}$). Autrement dit, à une largeur z du tronçon correspond une profondeur h de même concentration en oxygène interstitiel.

Ainsi, pour connaître la concentration en oxygène interstitiel [Oi] sur la profondeur h du tronçon 11, on mesure tout d'abord en surface la concentration [Oi](z) en plusieurs points répartis sur la largeur z du tronçon. Une formule mathématique ou un abaque permet ensuite de convertir chaque mesure [Oi](z) en une mesure [Oi](h) sur la profondeur h du tronçon, en déterminant la profondeur h équivalente à la position z de cette mesure. En effet, profondeur h et largeur z du tronçon sont liées par la relation suivante :

$$h = \frac{z}{\sin\left(\arctan\left(\frac{z}{R}\right)\right)} - R$$

où R correspond au rayon du lingot 1 auquel est retranché l'épaisseur maximale du tronçon 11 (cf. Fig.4).

Dans l'exemple de la figure 4, quatre points de mesure A, B, C et D, en plus de l'origine O', sont répartis sur une demi-largeur du tronçon 11. Les valeurs de concentration [Oi] mesurées aux points A, B, C et D, respectivement d'ordonnée (largeur z) égale à 2,8 cm, 4 cm, 5 cm et 5,8 cm, sont les mêmes qu'aux points A', B', C' et D' situés sur l'axe $\vec{h}$ et d'abscisse (profondeur h) égale à 0.5 cm, 1 cm, 1.5 cm et 2 cm respectivement. La mesure au point d'origine O' (z=0) donne la valeur de la concentration [Oi] pour une profondeur de tronçon nulle (h=0).

La figure 5 est un exemple d'abaque permettant la conversion entre la largeur z et la profondeur h du tronçon 11. Il a été établi à partir de la relation mathématique ci-dessus pour un lingot de 20 cm de diamètre (8 pouces) et un tronçon 11 de 2,5 cm d'épaisseur à son sommet.

Ainsi, grâce aux mesures de la concentration en oxygène sur la face plane 12 du tronçon 11 et de la formule de conversion (ou éventuellement d'un abaque tel que celui de la figure 5), il est possible de tracer la concentration en oxygène interstitiel [Oi](h) en périphérie du lingot, i.e. sur une profondeur égale à l'épaisseur maximale du tronçon 11.

Dans ce deuxième procédé de caractérisation, les mesures de la concentration en oxygène interstitiel [Oi](z) sont avantageusement réalisées grâce à la méthode du brevet FR2964459. La mesure FTIR est également possible, bien que moins appropriée. En effet, comme discuté précédemment, elle requiert une rectification de la face arrondie du tronçon. En outre, comme il s'agit d'une mesure traversante et non de surface, elle fournit une teneur en oxygène moyenne qui ne peut être assimilée à une concentration de surface que si l'échantillon est fin, typiquement jusqu'à 2 mm d'épaisseur. Avec la technique FTIR, le nombre de points de mesure sera par conséquent limité.

L'étape suivante consiste à extrapoler un profil radial [Oi](x) de la concentration en oxygène interstitiel dans le lingot, à partir des mesures [Oi](h) de la concentration en oxygène sur la profondeur du tronçon. Les mesures [Oi](h) obtenues à l'étape de la figure 4 représentent déjà plusieurs points de ce profil, car les points O', A', B', C' et D' sont situés sur un rayon du lingot 1 (l'axe $\vec{h}$ du tronçon 11 est superposé à l'axe Ox du lingot 1).

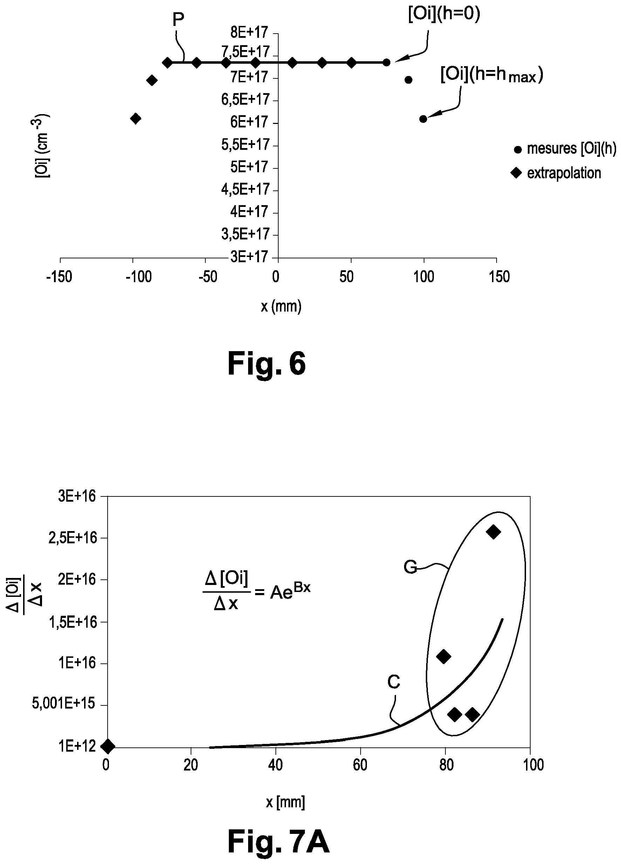

Dans un premier mode de mise en oeuvre représenté par la figure 6, la reconstruction du profil radial de la concentration [Oi] s'effectue en deux opérations :

- du fait de l'axi-symétrie de la répartition en oxygène dans un lingot Czochralski, les mesures [Oi](h) correspondant au tronçon 11 sont dupliquées d'une extrémité à l'autre du profil radial [Oi](x). Autrement dit, la valeur mesurée pour chaque coordonnée x positive du lingot est reproduite (par symétrie par rapport à l'axe des ordonnées) à une coordonnée x négative correspondante (i.e. de même valeur absolue).

- on reconstruit ensuite la partie du profil radial [Oi](x) situé entre ces deux extrémités - soit le coeur du lingot (centré sur x=0) - en supposant que cette partie centrale forme un plateau P de la concentration en oxygène interstitiel [Oi]. En effet, le procédé de cristallisation Czochralski conduit à une distribution radiale en oxygène sensiblement constante au coeur du lingot. On suppose ici que le plateau P est atteint par la mesure [Oi](h=0) située au bord intérieur du tronçon 11 (la face 12), c'est-à-dire pour la mesure ayant la plus petite valeur (positive) de x.

Dans ce mode de mise en oeuvre de l'étape d'extrapolation, plus le tronçon 11 est épais, plus la valeur [Oi](h=0) mesurée sur la face intérieure 12 du tronçon est proche de la valeur réelle au coeur du lingot (autour de x=0). L'épaisseur $h_{max}$ du tronçon 11 est avantageusement supérieure ou égale à 2 cm, de sorte qu'on obtienne une bonne précision lors de l'étape d'extrapolation de la figure 6. On notera à cet égard que les tronçons ou « slabs » découpés lors des étapes de « squaring » (« pseudo-sqaring » ou « full-squaring ») en vue de la fabrication de cellules photovoltaïques remplissent cette condition.

Il n'est pas obligatoire d'utiliser un tronçon entier pour mesurer les concentrations en oxygène [Oi](z). Le tronçon peut notamment être redécoupé ou « rectifié » en une tranche d'épaisseur plus faible pour en faciliter l'utilisation. De préférence, cette tranche est découpée parallèlement au premier plan de coupe du lingot (i.e. longitudinal). Plus ce premier plan de coupe est proche du centre du lingot, plus la valeur [Oi](h=0) mesurée sur la face intérieure 12 du tronçon rectifié est proche de la valeur réelle au coeur du lingot.

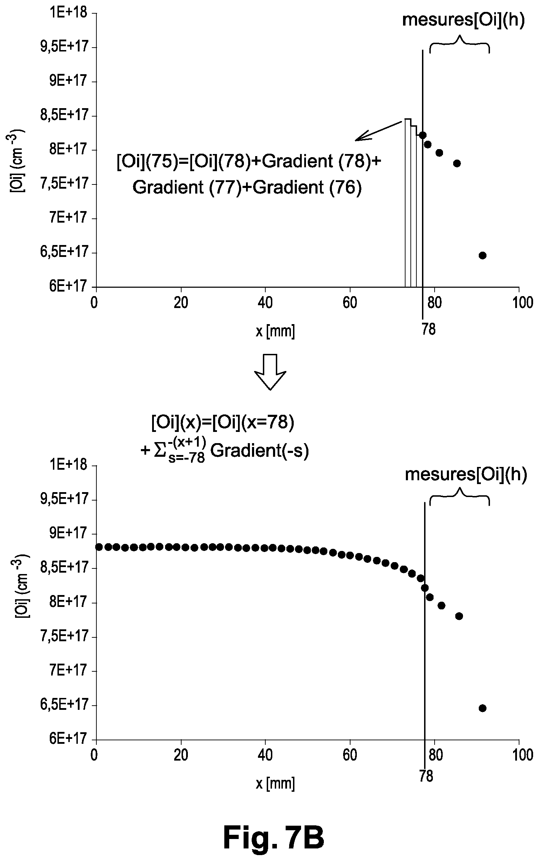

Les figures 7A et 7B représentent un deuxième mode de mise en oeuvre de l'étape d'extrapolation de la distribution radiale en oxygène interstitiel.

A l'étape de la figure 7A, le gradient de la concentration en oxygène interstitiel en fonction de la position radiale

$$\frac{\Delta[Oi]}{\Delta x}(x),$$

x, noté ci-après est calculé à partir des mesures [Oi](h) de la figure 6. On obtient alors un groupe G de points situés dans le domaine des x correspondant au tronçon 11 (de 80 mm à 100 mm environ sur la figure 7A). Ces points sont ensuite décrits par une courbe d'extrapolation C. La fonction associée à la courbe C s'écrit, de préférence, sous une forme exponentielle :

$$\frac{\Delta[Oi]}{\Delta x}(x) = Ae^{Bx}$$

où A et B sont des coefficients obtenus numériquement (pour faire coïncider la courbe C avec le groupe de points G).

L'étape de la figure 7B consiste ensuite à reconstruire, point par point, le profil radial [Oi](x), à partir des mesures initiales [Oi](h) et du gradient de la concentration en oxygène $\frac{\Delta[Oi]}{\Delta x}(x)$. Chaque nouveau point est obtenu en ajoutant à la valeur de la concentration en oxygène [Oi] du point précédent, qui peut être mesurée ou calculée, la valeur du gradient au point précédent (et qui est donnée par la fonction exponentielle ci-dessus). A titre d'exemple, partant de la dernière valeur mesurée à x = 78 mm, les valeurs de la concentration en oxygène [Oi] pour x = 77 mm, x = 76 mm et x = 75 mm sont:

$$[Oi](x = 77) = [Oi](x = 78) + \frac{\Delta[Oi]}{\Delta x}(x = 78)$$

$$[Oi](x = 76) = [Oi](x = 78) + \frac{\Delta[Oi]}{\Delta x}(x = 78) + \frac{\Delta[Oi]}{\Delta x}(x = 77)$$

$$[Oi](x = 75) = [Oi](x = 78) + \frac{\Delta[Oi]}{\Delta x}(x = 78) + \frac{\Delta[Oi]}{\Delta x}(x = 77) + \frac{\Delta[Oi]}{\Delta x}(x = 76)$$

La formule générale permettant de calculer tous les points du profil [Oi](x) autres que ceux issus des mesures (pour x < 78 mm) s'écrit :

$$[Oi](x) = [Oi](x = 78) + \sum_{s=-78}^{-(x+1)} \frac{\Delta[Oi]}{\Delta x}(-s)$$

où x = 78 mm est la position radiale du bord intérieur du tronçon, i.e. la position du plan de coupe du tronçon.

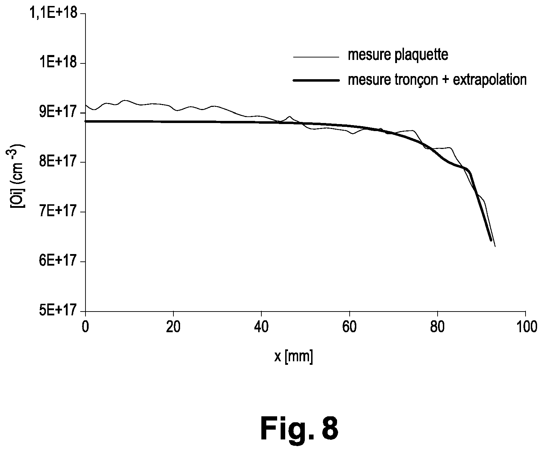

A titre de comparaison, la figure 8 représente un profil radial [Oi](x) mesuré sur le rayon d'une plaquette située à une fraction du lingot y donnée et celui obtenu par extrapolation des mesures du tronçon [Oi](h) à la même fraction. On remarque que les deux courbes concordent, ce qui signifie que la méthode d'extrapolation des figures 7A et 7B est correcte.

Une fois que le profil radial [Oi](x) est établi pour une fraction du lingot y donnée, les étapes précédentes de mesure et d'extrapolation sont réitérées pour différentes positions sur la longueur du lingot, c'est-à-dire pour d'autres valeurs de la fraction du lingot y.

Plusieurs profils radiaux, de préférence régulièrement répartis sur la longueur totale du lingot, sont ainsi obtenus. Enfin, une cartographie du lingot en silicium est établie par interpolation des différents profils radiaux. De préférence, le nombre de profils radiaux [Oi](x) calculés est supérieur à 5, avantageusement supérieur à 10, afin d'obtenir une cartographie précise de l'ensemble du lingot.

A nouveau, grâce à ce second procédé de caractérisation, on peut établir la cartographie complète de la concentration en oxygène interstitiel dans un lingot en silicium, en procédant à un nombre limité de mesures et sans qu'il soit nécessaire de découper entièrement le lingot en plaquettes de silicium.

Lorsqu'on sait que la concentration en oxygène interstitiel varie radialement dans les mêmes proportions tout au long du lingot (i.e. variation relative radiale constante), chacun des deux procédés de caractérisation qui viennent d'être décrits peut être appliqué pour dresser une carte de la concentration en oxygène interstitiel dans le lingot. Dans le cas contraire, lorsque le profil radial en oxygène varie longitudinalement, le deuxième procédé de caractérisation sera, de préférence, systématiquement appliqué.

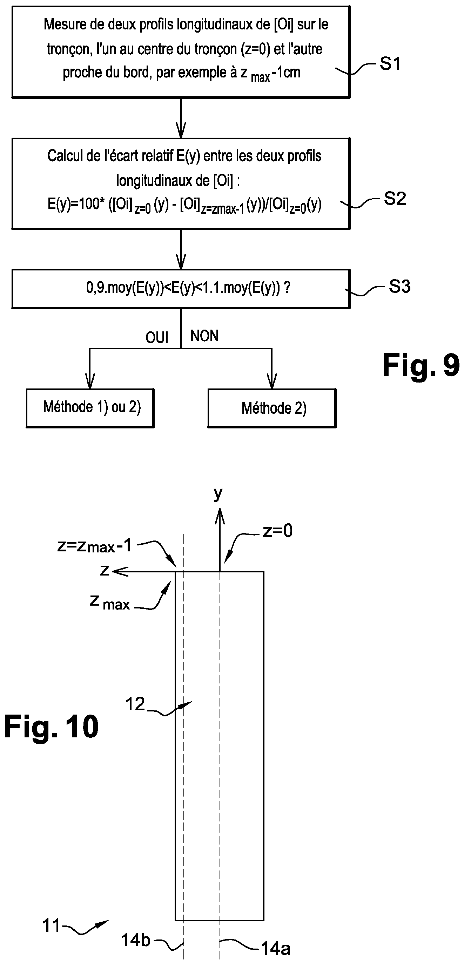

La figure 9 est un organigramme permettant de départager ces deux méthodes, lorsqu'on ignore le caractère constant de la distribution radiale en oxygène. Le schéma décisionnel se compose de trois étapes S1 à S3 qui visent à déterminer si le profil radial est constant ou non.

La première étape S1 consiste à mesurer deux profils longitudinaux de la concentration en oxygène [Oi] sur le tronçon. Ces deux profils sont désignés par les références 14a et 14b sur la figure 10 qui représente la face plane 12 du tronçon 11. De préférence, le profil 14a est situé au centre du tronçon (pour z = 0) et le profil 14b se situe près du bord de la face plane 12, par exemple à z=$z_{max}$-1 cm où $z_{max}$ est égal à la demi-largeur du tronçon 11. Les points de mesure sont, de préférence, répartis sur toute la longueur y du tronçon. Le nombre de points dans chaque profil 14a, 14b est supérieur à 5, avantageusement supérieur à 10, afin d'obtenir une représentation fidèle de la distribution en oxygène interstitiel le long du tronçon. Chaque point $[Oi]_{z=0}(y)$ de la série 14a peut être associé à un point $[Oi]_{z=zmax-1}(y)$ de la série 14b ayant la même coordonnée y, c'est-à-dire située dans la même fraction du lingot.

A l'étape S2 (Fig.9), l'écart relatif E(y) entre les deux profils longitudinaux 14a et 14b de la concentration en oxygène interstitiel est calculé. Pour cela, on utilise pour chaque couple de points associés - l'un provenant de la série 14a ($[Oi]_{z=0}(y)$) et l'autre de la série 14b ($[Oi]_{z=zmax-1}(y)$) - la relation suivante :

$$E(y) = 100 \times \frac{\left([Oi]_{z=0}(y) - [Oi]_{z=z_{max}-1}(y)\right)}{[Oi]_{z=0}(y)}$$

On obtient à l'issue de l'étape F2 plusieurs valeurs de l'écart relatif E(y) correspondant à plusieurs fractions de lingot y différentes.

Enfin, à l'étape S3, on vérifie si toutes les valeurs de la fonction E(y) ci-dessus remplissent la condition suivante :

$$0.9 \times moy\big(E(y)\big) \leq E(y) \leq 1.1 \times moy\big(E(y)\big)$$

c'est-à-dire si l'écart relatif E(y) n'évolue pas de plus de 10% de sa valeur moyenne moy(E(y)).

Lorsque cette condition est remplie (sortie OUI de l'étape S3 sur la figure 9), i.e. lorsqu'aucune des valeurs E(y) ne s'écarte de plus de 10 % de la valeur moyenne moy(E(y)), on considère que l'écart relatif E(y) entre le profil longitudinal central et celui du bord est pratiquement constant sur toute la longueur du lingot. Cela signifie que les deux profils longitudinaux 14a et 14b sont sensiblement parallèles entre eux.

Par conséquent, la concentration en oxygène évolue du même ordre de grandeur quelle que soit la position y dans le lingot. L'un ou l'autre des deux procédés de caractérisation peut donc être utilisé.

Lorsqu'au contraire, au moins l'un des points s'écarte de plus de 10% de la valeur moyenne moy(E(y)) (sortie NON en S3), la distribution radiale est considérée comme non uniforme et seule la seconde méthode de caractérisation pourra être utilisée.

Le premier procédé, décrit ci-dessus en relation avec les figures 1 à 3, est applicable à tout type de lingot semi-conducteur, de type monocristallin ou polycristallin, quelle que soit la méthode de solidification ayant permis de l'obtenir. Ce procédé peut également être appliqué aux briques issues du briquetage du lingot (en général, du Si-polycristallin). Le second procédé (Figs.4-8) est avantageusement utilisé pour caractériser des lingots monocristallins cristallisés selon la technique Czochralski ou le technique Kyropoulos. Par ailleurs, dans chacun de ces procédés, le matériau semi-conducteur peut être du germanium ou un alliage de silicium-germanium, plutôt que du silicium.

Enfin, outre la concentration en oxygène, ces deux procédés permettent de caractériser la concentration en donneurs thermiques s'étant formés pendant la cristallisation du lingot, à partir de l'oxygène interstitiel. On procèdera comme indiqué ci-dessus à des mesures de la concentration en donneurs thermiques, plutôt que de la concentration en oxygène interstitiel, sur le tronçon et (pour le premier procédé) sur une plaquette. On pourra notamment utiliser l'enseignement du document [« Mapping of Oxygen-Related Defects in Silicon for High Efficiency Solar Cells: Application to the Prediction of LID Losses, J. Veirman et al., 29th European PV Conference, Paris, September 2013] pour mesurer la concentration en donneurs thermiques sur le tronçon et la plaquette.

## Revendications

1. Procédé de détermination de la concentration en oxygène interstitiel ($[Oi](x, y)$) dans un lingot (1) en matériau semi-conducteur comprenant les étapes suivantes :

a) découper dans le lingot (1) un tronçon (11) selon un plan longitudinal du lingot ;
b) mesurer la concentration en oxygène interstitiel en plusieurs points (O', A, B, C, D) répartis sur une largeur (z) du tronçon (11) dans le plan de coupe longitudinal du lingot (1) ;
c) convertir les mesures (O', A, B, C, D) de la concentration en oxygène interstitiel sur la largeur (z) du tronçon (11) en des mesures (O', A', B', C', D') de la concentration en oxygène interstitiel sur une profondeur (h) du tronçon ;

d) extrapoler un profil radial ([Oi](x)) de la concentration en oxygène interstitiel dans le lingot (1) à partir des mesures ([Oi](h)) de la concentration en oxygène interstitiel sur la profondeur (h) du tronçon (11) ;

e) répéter les étapes b) à d) en différentes zones réparties le long du tronçon (11), d'où il résulte une pluralité de profils radiaux ([Oi](x)) de la concentration en oxygène interstitiel dans le lingot (1) ; et

f) corréler les profils radiaux ([Oi](x)) pour déterminer la concentration en oxygène interstitiel ([Oi](x, y)) dans chaque zone du lingot (1).

2. Procédé selon la revendication 1, comprenant en outre une étape de détermination d'un gradient de la concentration en oxygène sur un rayon du lingot (1), à partir des mesures ([Oi](h)) de la concentration en oxygène interstitiel sur la profondeur (h) du tronçon (11), et dans lequel le profil radial ([Oi](x)) de la concentration en oxygène interstitiel est extrapolé à l'étape d) au moyen dudit gradient de la concentration en oxygène.

3. Procédé selon la revendication 1, dans lequel le découpage du tronçon (11) dans le lingot (1) est réalisé de sorte que le tronçon ait une épaisseur maximale supérieure ou égale à 2 cm.

4. Procédé selon l'une quelconque des revendications 1 à 3, dans lequel les mesures ([Oi](z)) de la concentration en oxygène interstitiel sur la largeur du tronçon (11) sont converties en mesures ([Oi](h)) de la concentration en oxygène interstitiel sur une profondeur (h) du tronçon en déterminant, pour chaque point de mesure (O', A, B, C, D), la profondeur équivalente (h) dans le tronçon (11).

5. Procédé selon l'une quelconque des revendications 1 à 4, dans lequel les étapes b) à d) sont répétées en au moins cinq zones du lingot (1).

6. Procédé selon l'une quelconque des revendications 1 à 5, dans lequel la concentration en oxygène interstitiel ([Oi](z)) est mesurée à l'aide des étapes suivantes :

- soumettre le tronçon (11) à un traitement thermique de manière à former des donneurs thermiques ;
- mesurer la variation de résistivité causée par les donneurs thermiques ;
- calculer la concentration en donneurs thermiques à partir de la variation de résistivité ; et
- déterminer la concentration en oxygène interstitiel ([Oi](z)) à partir de la concentration en donneurs thermiques.

**Patentansprüche**

1. Bestimmungsverfahren der Konzentration an interstitiellem Sauerstoff ([Oi] (x, y)) in einem Ingot (1) aus Halbleitermaterial, umfassend die folgenden Schritte:

a) Ausschneiden eines Abschnitts (11) aus dem Ingot (1) gemäß einer Längsebene des Ingots;

b) Messen der Konzentration an interstitiellem Sauerstoff an mehreren Punkten (O' A, B, C, D), die über eine Breite (z) des Abschnitts (11) in der Ebene des Längsschnitts des Ingots (1) verteilt sind;

c) Umwandeln der Maße (O', A, B, C, D) der Konzentration an interstitiellem Sauerstoff über die Breite (z) des Abschnitts (11) in Maße (O', A', B', C', D') der Konzentration an interstitiellem Sauerstoff über eine Tiefe (h) des Abschnitts;

d) Extrapolieren eines radialen Profils ([Oi] (x)) der Konzentration an interstitiellem Sauerstoff in dem Ingot (1) ausgehend von den Messungen ([Oi] (h)) der Konzentration an interstitiellem Sauerstoff über die Tiefe (h) des Abschnitts (11);

e) Wiederholen der Schritte b) bis d) in unterschiedlichen Bereichen, die entlang den Abschnitt (11) verteilt sind, aus dem eine Vielzahl von radialen Profilen ([Oi] (x)) der Konzentration an interstitiellem Sauerstoff in dem Ingot (1) resultiert; und

f) Korrelieren der radialen Profile ([Oi] (x)) zum Bestimmen der Konzentration an interstitiellem Sauerstoff ([Oi] (x, y)) in jedem Bereich des Ingots (1).

2. Verfahren gemäß Anspruch 1, umfassend darüber hinaus einen Bestimmungsschritt eines Gradienten der Sauerstoffkonzentration über einen Radius des Ingots (1) ausgehend von Messungen ([Oi] (h)) der Konzentration an interstitiellem Sauerstoff über die Tiefe (h) des Abschnitts (11) und bei dem das radiale Profil ([Oi] (x) der Konzentration an interstitiellem Sauerstoff in Schritt d) mittels des genannten Gradienten der Sauerstoffkonzentration extrapoliert ist.

**3.** Verfahren gemäß Anspruch 1, bei dem das Ausschneiden des Abschnitts (11) in dem Ingot (1) derart realisiert ist, dass der Abschnitt eine maximale Dicke von mehr als oder gleich 2 cm hat.

**4.** Verfahren gemäß irgendeinem der Ansprüche 1 bis 3, bei dem die Maße ([Oi] (z)) der Konzentration an interstitiellem Sauerstoff über die Breite des Abschnitts (11) in Maße ([Oi] (h)) der interstitiellen Sauerstoffkonzentration über eine Tiefe (h) des Abschnitts umgewandelt sind, indem für jeden Messpunkt (O', B, C, D) die äquivalente Tiefe (h) im Abschnitt (11) bestimmt wird.

**5.** Verfahren gemäß irgendeinem der Ansprüche 1 bis 4, bei dem die Schritte b) bis d) in wenigstens fünf Bereichen des Ingots (1) wiederholt werden.

**6.** Verfahren gemäß irgendeinem der Ansprüche 1 bis 5, bei dem die Konzentration an interstitiellem Sauerstoff ([Oi] (z)) mittels der folgenden Schritte gemessen wird:

- Unterziehen des Abschnitts (11) einer Wärmebehandlung derart, dass thermische Donatoren gebildet werden;
- Messen der Abweichung des Leistungswiderstandes, die von den thermischen Donatoren verursacht wird;
- Berechnen der Konzentration der thermischen Donatoren ausgehend von der Abweichung des Leistungswiderstandes; und
- Bestimmen der interstitiellen Sauerstoffkonzentration (Oi) (z)) ausgehend von der Konzentration an thermischen Donatoren.

**Claims**

**1.** Method for determining the interstitial oxygen concentration ([Oi](x, y)) in an ingot (1) of semiconductor material, comprising the following steps of:

a) cutting a slab (11) from the ingot (1) along a longitudinal plane of the ingot;
b) measuring the interstitial oxygen concentration at several points (O', A, B, C, D) distributed on a width (z) of the slab (11) in the longitudinal cutting plane of the ingot (1) ;
c) converting the measurements (O', A, B, C, D) of the interstitial oxygen concentration on the width (z) of the slab (11) into measurements (O', A', B', C', D') of the interstitial oxygen concentration on a depth (h) of the slab;
d) extrapolating a radial profile ([Oi](x)) of the interstitial oxygen concentration in the ingot (1) from the measurements ([Oi](h)) of the interstitial oxygen concentration on the depth (h) of the slab (11);
e) repeating steps b) to d) at different zones distributed along the slab (11), resulting in a plurality of radial profiles ([Oi](x)) of the interstitial oxygen concentration in the ingot (1); and
f) correlating the radial profiles ([Oi](x)) in order to determine the interstitial oxygen concentration ([Oi](x, y)) in each zone of the ingot (1).

**2.** Method according to claim 1, further comprising a step of determining a gradient of the oxygen concentration on a radius of the ingot (1), from the measurements ([Oi](h)) of the interstitial oxygen concentration on the depth (h) of the slab (11), and wherein the radial profile ([Oi] (x)) of the interstitial oxygen concentration is extrapolated in step d) by means of said gradient of the oxygen concentration .

**3.** Method according to claim 1, wherein cutting of the slab (11) from the ingot (1) is made such that the slab has a maximum thickness higher than or equal to 2 cm.

**4.** Method according to any of claims 1 to 3, wherein the measurements ([Oi](z)) of the interstitial oxygen concentration on the width of the slab (11) are converted into measurements ([Oi](h)) of the interstitial oxygen concentration on a depth (h) of the slab by determining, for each measurement point (O', A, B, C, D), the equivalent depth (h) in the slab (11).

**5.** Method according to any of claims 1 to 4, wherein steps b) to d) are repeated at least at five zones of the ingot (1).

**6.** Method according to any of claims 1 to 5, wherein the interstitial oxygen concentration ([Oi](z)) is measured using the following steps of:

- subjecting the slab (11) to a heat treatment so as to form thermal donors;

- measuring the resistivity variation caused by the thermal donors;
- calculating the thermal donors concentration from the resistivity variation; and
- determining the interstitial oxygen concentration ($[Oi](z)$) from the thermal donors concentration.

**Fig. 1**

**Fig. 2A**

**Fig. 2B**

**Fig. 3A**

$$f(y)=2{,}49.10^{-4}.y^3 - 2{,}66.10^{-2}.y^2 + 1{,}54.10^{-1}.y + 9{,}86.10^1$$

y : fraction de la longueur du tronçon (%)

**Fig. 3B**

Iso courbes: ([O$_i$]/10$^{17}$)cm$^{-3}$

Fig. 3C

**Fig. 4**

**Fig. 5**

**Fig. 6**

$$\frac{\Delta[Oi]}{\Delta x} = Ae^{Bx}$$

**Fig. 7A**

Fig. 7B

**Fig. 8**

Mesure de deux profils longitudinaux de [Oi] sur le tronçon, l'un au centre du tronçon (z=0) et l'autre proche du bord, par exemple à $z_{max}$-1cm   S1

Calcul de l'écart relatif E(y) entre les deux profils longitudinaux de [Oi] :
$E(y)=100 \cdot ([Oi]_{z=0}(y) - [Oi]_{z=zmax-1}(y))/[Oi]_{z=0}(y)$   S2

$0,9.moy(E(y)) < E(y) < 1.1.moy(E(y))$ ?   S3

OUI | NON

**Fig. 9**

Méthode 1) ou 2)

Méthode 2)

y

z=0

$z=z_{max}-1$

z

$z_{max}$

12

**Fig. 10**

11

14b

14a

## RÉFÉRENCES CITÉES DANS LA DESCRIPTION

**Documents brevets cités dans la description**

- FR 2964459

- EP 0020993 A

**Littérature non-brevet citée dans la description**

- **J. VEIRMAN et al.** Mapping of Oxygen-Related Defects in Silicon for High Efficiency Solar Cells: Application to the Prediction of LID Losses. *29th European PV Conference,* Septembre 2013